# EUROPEAN PATENT APPLICATION

(11) **EP 1 416 778 A2**
(43) Date of publication of application: **06.05.2004**
(21) Application number: 03256881.8
(22) Date of filing: 30.10.2003
(51) Int. Cl.: H05K 1/14, H05K 3/34

(54) **Small and securely-soldered electronic unit**

(30) Priority: 01.11.2002 JP 2002006978
(71) Applicant: ALPS ELECTRIC CO., LTD., Ota-ku Tokyo 145 (JP)
(72) Inventor: Yatsu, Hiroyuki, Ota-ku Tokyo 145 (JP)
(74) Representative: Kensett, John Hinton

(57) **Abstract**

An electronic unit includes a module (1) in which a semiconductor device (3) is attached on the bottom of a circuit board (2) and which has lands (4) provided on the bottom of the circuit board, and a printed circuit board (5) on which the module is mounted, the printed circuit board having a hole (5a) in a position facing the semiconductor device and having electrical conductors (6) to which the lands are soldered. The module is mounted on the printed circuit board by soldering the lands to the electrical conductors while the semiconductor device is disposed in the hole. Accordingly, the electronic unit is smaller in height than conventional electronic units. Such a structure allows the module to be surface-mounted on the printed circuit board with solder paste, and thus high productivity of the electronic unit can be achieved.

## Description

### BACKGROUND OF THE INVENTION

### 1. Field of the Invention

The present invention relates to an electronic unit suitable for use in short-distance radio systems and the like.

### 2. Description of the Related Art

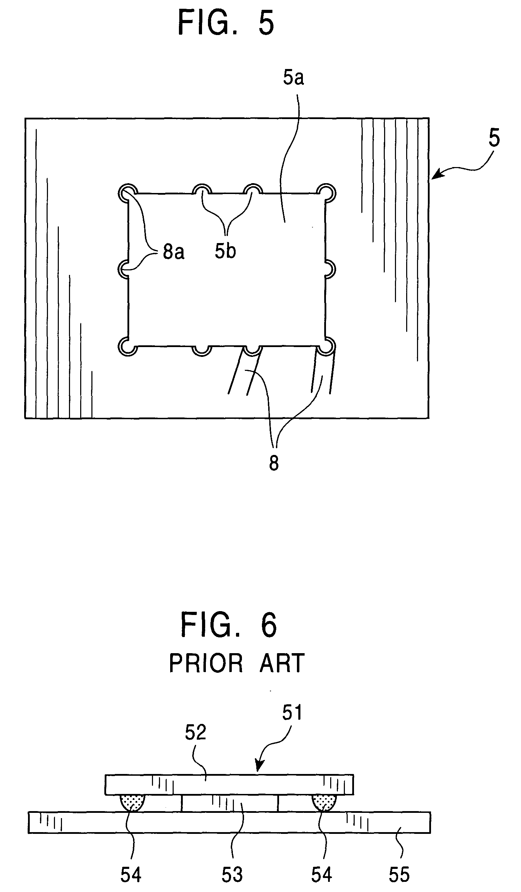

Referring to the structure of a conventional electronic unit shown in Fig. 6, a module 51 is composed of a circuit board 52 that comprises laminated layers, a semiconductor device 53 that is attached in the center of the bottom of the circuit board 52, a plurality of lands (not shown) that have an electrical conductive pattern provided on the bottom of the circuit board 52 around the periphery of the semiconductor device 53, and solder balls 54 that are applied on the lands.

The solder balls 54 are larger in height than the semiconductor device 53, the top of each solder ball 54 protruding downward relative to the bottom of the semiconductor device 53.

A printed circuit board 55, that is, a motherboard, is, for example, a multilayer board with a wiring pattern (not shown) on the surface. The wiring pattern has electrical conductors (not shown) in positions facing the solder balls 54.

In the module 51, the solder balls 54 are placed on the electrical conductors of the printed circuit board 55, and the semiconductor device 53 is attached to the bottom face of the circuit board 52. Conveying such a printed circuit board 55 to a reflow soldering apparatus and the like will allow the solder balls 54 to melt, and thereby the lands of the module 51 and the electrical conductors of the printed circuit board 55 will be soldered together.

Conventional electronic units thus manufactured have the problem that the semiconductor device 53 abuts on the printed circuit board 55 at the bottom; therefore, the electronic units become large in the height.

In addition, conventional electronic units also have the problem that the solder balls 54, which are larger in height than the semiconductor device 53, not only make the preparation of the solder balls 54 time-consuming, but also result in variations in the height, causing less reliable soldering.

### SUMMARY OF THE INVENTION

Accordingly, it is an object of the present invention to provide an electronic unit which has a low profile and in which soldering is performed with high reliability.

According to one aspect of the invention, an electronic unit comprises a module in which a semiconductor device is attached on the bottom of a circuit board and which has lands provided on the bottom of the circuit board with the lands being connected to the semiconductor device, and a printed circuit board on which the module is mounted. The printed circuit board has a hole in a position facing the semiconductor device and has electrical conductors to which the lands are soldered, and the module is mounted on the printed circuit board by soldering the lands to the electrical conductors while the semiconductor device is disposed in the hole.

Preferably, the lands and the electrical conductors are soldered together with solder balls that are placed on the lands.

Preferably, the wall of the hole in the printed circuit board has recesses that have the electrical conductors applied thereto and receive the corresponding solder balls.

Embodiments of the invention will now be described, by way of example only, with reference to the accompanying drawings, in which:
Fig. 1 is a sectional view showing the principal part of an electronic unit according to a first embodiment of the invention.
Fig. 2 is a bottom view showing a module of the electronic unit according to the first embodiment of the invention.
Fig. 3 is a sectional view showing the principal part of an electronic unit according to a second embodiment of the invention.
Fig. 4 is a bottom view showing a module of the electronic unit according to the second embodiment of the invention.
Fig. 5 is a plan view showing a printed circuit board of the electronic unit according to the second embodiment of the invention.
Fig. 6 is a front view of a conventional electronic unit.

### DESCRIPTION OF THE PREFERRED EMBODIMENTS

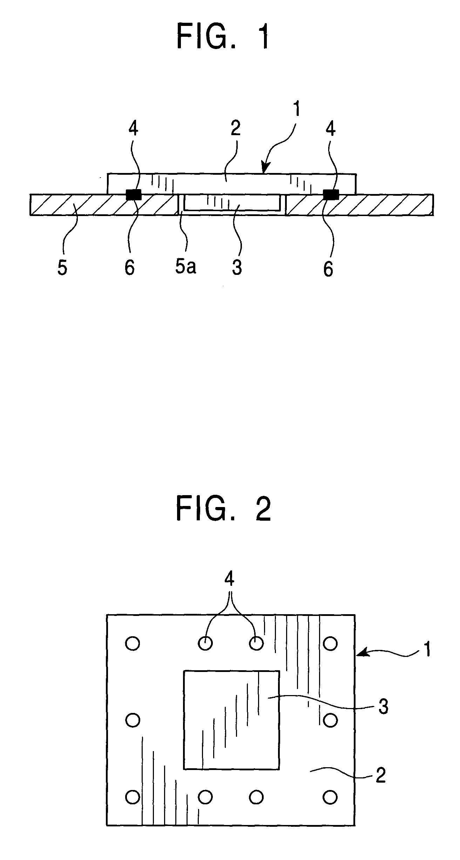

Referring to Figs. 1 and 2, a module 1 is composed of a circuit board 2 that comprises laminated layers, a semiconductor device 3 that is attached in the center of the bottom of the circuit board 2, and a plurality of lands 4 that have an electrical conductive pattern provided on the bottom of the circuit board 2 around the periphery of the semiconductor device 3.

A printed circuit board 5, that is, a motherboard, is, for example, a multilayer board with a hole 5a in a position facing the semiconductor device 3 and wiring pattern (not shown) on the surface. The wiring pattern has electrical conductors 6, that is, lands, in positions facing the lands 4.

In the module 1, the circuit board 2 is mounted on the printed circuit board 5 such that the semiconductor device 3 is disposed downward in the hole 5a.

Thus the lands 4 are mounted on solder paste (not shown) applied on the electrical conductors 6 of the printed circuit board 5. Conveying such a printed circuit board 5 to a reflow soldering apparatus will allow the solder paste to melt, and thereby the lands 4 and the electric conductors 6 are soldered together.

As a result, such a structure of the present invention allows the module 1 to be surface-mounted on the printed circuit board 5 with solder paste while the semiconductor device 3 is disposed in the hole 5a. Therefore, an electronic unit that is smaller in height than conventional electronic units can be formed with high productivity.

Furthermore, although the solder paste was used in the above-described first embodiment, solder balls that are formed on the lands 4 and are smaller in height than the semiconductor device 3 may be used.

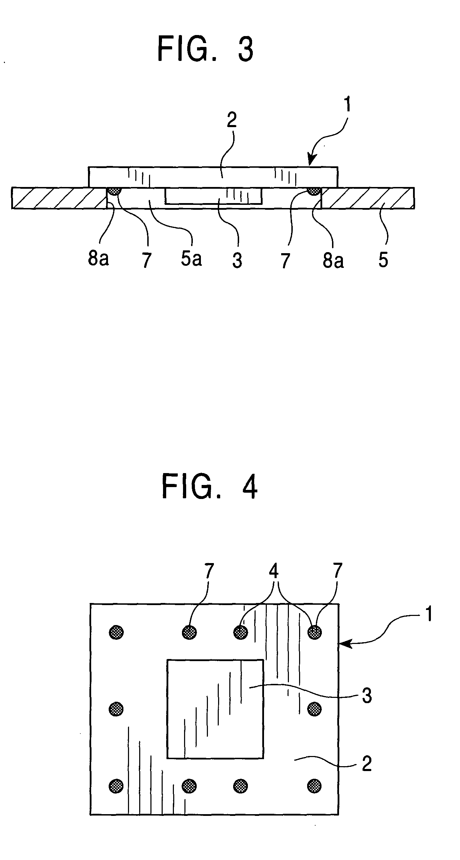

Referring to Figs. 3 to 5, which show a second embodiment of the electronic unit according to the invention, a module 1 is composed of a circuit board 2 that comprises laminated layers, a semiconductor device 3 that is attached in the center of the bottom of the circuit board 2, a plurality of lands 4 that have an electrical conductive pattern provided on the bottom of the circuit board 2 around the periphery of the semiconductor device 3, and solder balls 7 that are applied on the lands 4.

The printed circuit board 5, that is, a motherboard, is, for example, a multilayer board with a hole 5a in a position facing the semiconductor device 3. The wall of the hole 5a has recesses 5b corresponding to the solder balls 7.

In addition, wiring patterns 8 are provided on the printed circuit board 5 and between the laminated layers. Electrical conductors 8a are applied to the walls of the recesses 5b and are electrically connected with the wiring patterns 8.

In the module 1, the circuit board 2 is mounted on the printed circuit board 5 such that the semiconductor device 3 is disposed downward in the hole 5a.

The solder balls 7 are thereby placed in the recesses 5b of the printed circuit board 5. Conveying such a printed circuit board 5 to a reflow soldering apparatus will allow the solder balls 7 to melt, and thus the lands 4 and the electrical conductors 8a are soldered together.

As a result, the module 1 can be surface-mounted on the printed circuit board 5 with small solder balls 7 while the semiconductor device 3 is disposed in the hole 5a. Therefore, the soldering is highly reliable and an electronic unit having a low profile can be manufactured with high productivity.

Furthermore, since the recesses 5b have electrical conductors 8a on the walls thereof and receive the corresponding solder balls 7, it is not particularly necessary to lead the wiring patterns 8 provided between the laminated layers out to the surface of the printed circuit board 5. Accordingly, continuity between the module 1 and the wiring patterns 8 is excellent.

## Claims

1. An electronic unit comprising:
a module in which a semiconductor device is attached on the bottom of a circuit board and which has lands provided on the bottom of the circuit board with the lands being connected to the semiconductor device; and
a printed circuit board on which the module is mounted,
the printed circuit board having a hole in a position facing the semiconductor device and having electrical conductors to which the lands are soldered,
wherein the module is mounted on the printed circuit board by soldering the lands to the electrical conductors while the semiconductor device is disposed in the hole.

2. An electronic unit according to Claim 1, wherein solder balls are applied on the lands, and the lands and the electric conductors are soldered together with the solder balls.

3. An electronic unit according to Claim 2, wherein the wall of the hole has recesses that receive the corresponding solder balls and have electrical conductors applied to the walls of the recesses.
